# EUROPÄISCHE PATENTANMELDUNG

(11) **EP 1 416 783 A1**
(43) Veröffentlichungstag der Anmeldung: **06.05.2004**
(21) Anmeldenummer: 02024207.9
(22) Anmeldetag: 30.10.2002
(51) Int. Cl.: H05K 7/20

(54) **Anordnung zur Klimatisierung einer Basisstation**

(71) Anmelder: SIEMENS AKTIENGESELLSCHAFT, 80333 München (DE)
(72) Erfinder: Kraus, Harald, 89415 Lauingen (DE); Tobi, Reinhard, 85560 Ebersberg (DE)

(57) **Zusammenfassung**

Die Erfindung betrifft eine Anordnung zur Klimatisierung einer Basisstation eines Funkkommunikationssystems, wobei die Basisstation zu klimatisierende Baugruppen und Klimatisierungseinrichtungen aufweist.

Erfindungsgemäß wird jeder zu klimatisierenden Baugruppe eine Klimatisierungseinrichtung zur baugruppenspezifischen Klimatisierung zugeordnet. Weiter wird jeder zu klimatisierenden Baugruppe jeweils eine Messeinrichtung zur Bestimmung einer baugruppenspezifischen Temperatur zugeordnet. Die Basisstation beinhaltet eine Logikeinrichtung, an die jede Klimatisierungseinrichtung und jede Messeinrichtung angeschlossen ist, wobei mit Hilfe der Logikeinrichtung gemessene baugruppenspezifische Temperaturen ausgewertet und die jeweiligen Klimatisierungseinrichtungen zum Temperaturausgleich entsprechend gesteuert werden.

## Beschreibung

Die Erfindung betrifft eine Anordnung zur Klimatisierung einer Basisstation eines Funkkommunikationssystems, wobei die Basisstation zu klimatisierende Baugruppen und Klimatisierungseinrichtungen aufweist.

Zur Klimatisierung von Mobilfunk-Basisstationen werden einerseits Lüfter und andererseits Heizungen verwendet. Ein derartiger Lüfter weist dabei eine Speichereinrichtung mit einer dort fest abgespeicherten Lüfterkennlinie auf. Basierend auf Temperaturmessungen wird mit Hilfe einer durch die fest abgespeicherte Lüfterkennlinie vorgegebenen Lüfterdrehzahl bzw. mit Hilfe einer Heizung die Basisstation gekühlt bzw. erwärmt.

Dabei wird bei einem ersten Klimatisierungskonzept an einer Gehäusewand der Basisstation eine Lufteintrittstemperatur bestimmt. Bei einem zweiten Klimatisierungskonzept wird an einer Gehäusewand der Basisstation eine Luftaustrittstemperatur bzw. eine Ablufttemperatur bestimmt.

Basierend darauf werden Lüfter der oben beschriebenen Bauart, die an der Gehäusewand angeordnet sind, oder eine Basisstationsheizung zur Klimatisierung entsprechend angesteuert.

Beim ersten Klimatisierungskonzept bestimmen vorbekannte Verhältnisse zwischen Lufteintrittstemperatur einerseits und im Inneren der Basisstation vorherrschenden Temperaturen andererseits die Klimatisierung. Es erfolgt kein Rückschluss auf Baugruppentemperaturen und auf eine damit verbundene Erhöhung der Ablufttemperatur der Basisstation.

Beim zweiten Klimatisierungskonzept bestimmen gemittelte Temperaturen über alle Baugruppen die Luftaustrittstemperatur und damit die Klimatisierung. Mischtemperaturen entstehen dadurch, dass einzelne Baugruppen im Betrieb sind und andere nicht. Wärmeübergänge innerhalb der Basisstation werden nicht erfasst bzw. nicht berücksichtigt. Daraus folgt eine systembedingte Trägheit zwischen interner Baugruppentemperatur einerseits und einer momentanen Lüfterdrehzahl andererseits.

Da die Kühlung unter Einsatz von Lüftern mit fest vorgegebenen Lüfterkennlinien erfolgt, müssen bei einer nachträglichen Erweiterung der Basisstation um zusätzliche Baugruppen die Lüfter getauscht werden, da sich im Inneren der Basisstation andere Temperaturverhältnisse bilden.

Da bei den bisher bekannten Klimatisierungssystemen die Lüfterkennlinien exakt für jede einzelne Basisstation abgestimmt werden müssen, entsteht eine kostspielige Vielfalt an verschiedenen Lüftertypen.

Es ist Aufgabe der vorliegenden Erfindung, die Klimatisierung von Basisstationen zu verbessern.

Diese Aufgabe wird gelöst durch die Merkmale des Patentanspruchs 1. Vorteilhafte Weiterbildungen sind in den Unteransprüchen angegeben.

Durch die erfindungsgemäße Anordnung wird insbesondere die Typenvielfalt bei den zur Kühlung verwendeten Lüftern reduziert, da die verwendeten Lüfter nunmehr unabhängig von der elektrischen Funktion der Basisstationen bzw. unabhängig von der dort verwendeten Baugruppenanzahl einsetzbar sind. Bei einer Basisstationserweiterung werden entsprechende Lüfterkennlinien mit Hilfe von Software von außen modifiziert.

Durch die erfindungsgemäße Anordnung werden baugruppenspezifische Temperaturen bestimmt und jede Baugruppe für sich wird unmittelbar klimatisiert.

Durch die erfindungsgemäße Anordnung erfolgt auch beim Ruhezustand der Basisstation eine optimale Klimatisierung.

Durch die erfindungsgemäße Anordnung wird eine dynamische Klimatisierung mit vernachlässigbarer Trägheit erzielt.

Im Folgenden wird ein Ausführungsbeispiel der Erfindung anhand einer Zeichnung näher erläutert. Dabei zeigt:

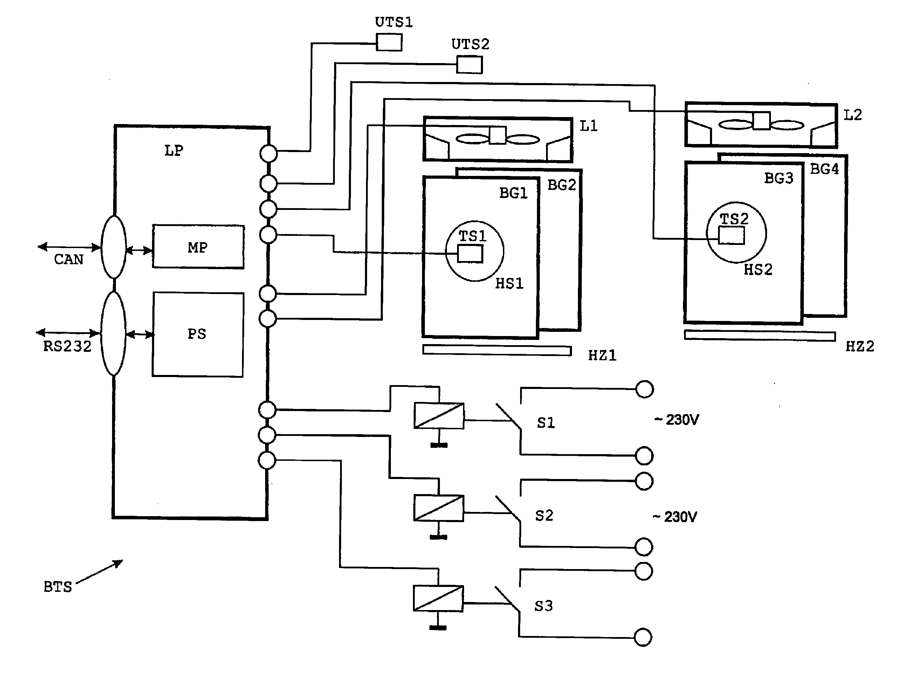

- FIG 1.: eine erfindungsgemäße Anordnung zur Klimatisierung einer Basisstation.

FIG 1 zeigt eine Klimatisierung einer Basisstation BTS gemäß der Erfindung.

Eine Basisstation BTS beinhaltet mehrere zu klimatisierende Baugruppen BG1 bis BG4. Dabei werden den Baugruppen BG1 und BG2 ein Lüfter L1 als Kühleinrichtung sowie eine Heizung HZ1 als Heizeinrichtung zugeordnet und den Baugruppen BG3 und BG4 ein Lüfter L2 als Kühleinrichtung und eine Heizung HZ2 als Heizeinrichtung zugeordnet. Die Kühl- und die Heizeinrichtung bilden zusammen eine Klimatisierungseinrichtung.

Der zu klimatisierenden Baugruppe BG1 bzw. BG3 ist jeweils ein Temperatursensor TS1 bzw. TS3 als Temperatur-Messeinrichtung zugeordnet, der bevorzugt an einem sogenannten "Hot-Spot" HS1 bzw. HS3 der zu klimatisierenden Baugruppe BG1 bzw. BG3 angeordnet ist.

Hier nicht dargestellt sind weitere Temperatursensoren zur Temperaturmessung der Baugruppen BG2 bzw. BG4, wobei deren Aufgabe auch von den jeweiligen Temperatursensoren TS1 bzw. TS2 der benachbarten Baugruppen BG1 bzw. BG2 mitübernommen werden kann.

Die Basisstation BTS beinhaltet eine Logikplatine LP als Logikeinrichtung, die zur Auswertung gemessener Temperaturen und zur Ansteuerung der Lüfter L1, L2 und der Heizungen HZ1, HZ2 verwendet wird. Die Lüfter L1 und L2 sowie die Heizungen HZ1 und HZ2 sind über Steuerleitungen mit der Logikplatine verbunden.

Weiterhin weist die Basisstation BTS Temperatursensoren UTS1 und UTS2 als Messeinrichtung auf, wobei mit Hilfe des Temperatursensors UTS1 eine Umlufttemperatur bzw. eine Umgebungstemperatur innerhalb und mit Hilfe des Temperatursensors UTS2 die Umlufttemperatur bzw. Umgebungstemperatur außerhalb der Basisstation BTS bestimmt wird.

Die Temperatursensoren UTS1, UTS2, TS1 und TS2 sind mit der Logikplatine LP zur Temperaturmesswertübertragung verbunden.

Mit Hilfe der Logikplatine LP werden sowohl Umlufttemperaturen als auch baugruppenspezifische Temperaturen erfasst und die jeweils entsprechenden Kühl- bzw. Heizeinrichtungen entsprechend gesteuert. Zusätzlich werden mit Hilfe der Logikplatine LP hier nicht dargestellte Lüftungsklappen der Basisstation BTS gesteuert, die zur Wärmeabfuhr bzw. zum Wärmerückhalt verwendbar sind.

Die Logikplatine LP weist einerseits einen Mikroprozessor MP und andererseits einen Programmspeicher PS auf. Der Programmspeicher ist beispielsweise über eine Schnittstelle RS232 mit einer Steuerlogik verbunden, über die beispielsweise ein Servicetechniker bei einer Erweiterung der Basisstation BTS um zusätzliche Baugruppen neue Lüfterkennlinien für die Lüfter L1 und L2 einspeisen kann.
Der Mikroprozessor ist beispielsweise über einen optionalen CAN-Bus von außen ansteuerbar. Eine Fernüberwachung der Basisstation BTS mit Messwertübertragung ist mittels RS232-Schnittstelle bzw. über den CAN-Bus leicht realisierbar.

Dabei dient der Programmspeicher PS zur Speicherung eines Mess- und Steuerungsprogramms sowie von Messwerten, während der Mikroprozessor MP zur Temperaturauswertung und zur Steuerung der Klimatisierungseinrichtungen verwendet wird.

Besonders vorteilhaft sind die einzelnen Lüfterkennlinien der Lüfter L1 und L2 nicht mehr fest im Lüfter L1 bzw. L2 hinterlegt, sondern werden auf der Logikplatine LP abgespeichert und sind mit Hilfe der RS232-Schnittstelle bzw. mit Hilfe des CAN-Bus dynamisch anpassbar. Ein Steuerungsprogramm zur Klimatisierung der Basisstation BTS wird basisstationsspezifisch mit Hilfe der RS232-Schnittstelle bzw. mit Hilfe des CAN-Bus auf der Logikplatine abgelegt.

Die Heizung HZ1 wird beispielsweise mit Hilfe eines Schalters S1 angesteuert, indem bei geschlossenem Schalter S1 eine Heizspannung von 230V an die Heizung HZ1 angeschaltet wird. Entsprechend ist für die Heizung HZ2 ein Schalter S2 vorgesehen.

Mit Hilfe eines Schalters S3 wird die Funktion der Logikplatine LP überwacht bzw. fernüberwacht.

Bei einem Ausfall von Temperaturmesseinrichtungen ist in einem Notbetrieb vorgesehen, dass alle Lüfter L1 bzw. L2 mit ihrer maximalen Drehzahl betrieben werden.

Mit Hilfe der Logikplatine LP werden einzelne Betriebszustände wie Temperatur und Lüfterdrehzahl zu Dokumentationszwecken gespeichert und sind bei Bedarf von der Fernüberwachung abrufbar.

Zusammenfassend sind als Vorteile der Erfindung zu nennen:
- Die Temperatur jeder einzelnen zu klimatisierenden Baugruppe wird überwacht und kann jeweils über die zugeordnete Heizung bzw. über den Lüfter gezielt beeinflusst werden. Dadurch ist eine gezielte individuelle Klimatisierung möglich.
- Da die jeweilige Lüfterdrehzahl logikgesteuert vorgegeben wird, entfällt ein Abspeichern einer Lüfterkennlinie bei jedem einzelnen Lüfter. Beim Lüfter werden auf kostenintensive Speicher- und Steuerungskomponenten verzichtet.
- Die verwendeten Lüfter sind mit Hilfe der Logikplatine von ihrer Bauart her unabhängig von Änderungen bei der Basisstation bzw. von der Anzahl der dort verwendeten Baugruppen.
- Bei einem defekten Lüfter einer ersten Baugruppe wird dessen Aufgabe von benachbarten Lüftern mitübernommen, eine dynamisch einstellbare Klimatisierung mit Redundanz wird erzielt.
- Die erfindungsgemäße Klimatisierung ist kundenspezifisch anpassbar - beispielsweise an beliebige Outdoor- bzw. Indoor-Anwendungen, Standortregionen und Lärmgrenzwerte. Mit Hilfe von weiteren Messeinrichtungen bei der Basisstation werden Sonneneinwirkung, Feuchte und MEF-Ver-schmutzung (Luftfilterverschmutzung) erfasst und bei der Steuerung der Klimatisierungseinrichtungen entsprechend berücksichtigt.
- Die sogenannte "Mean Time Between Failure" MTBF der Baugruppen wird erhöht und eine Energieeinsparung ist erreichbar.

## Patentansprüche

1. Anordnung zur Klimatisierung einer Basisstation, wobei die Basisstation mehrere zu klimatisierende Baugruppen und Klimatisierungseinrichtungen aufweist,
**dadurch gekennzeichnet,**
- **dass** jeder zu klimatisierenden Baugruppe eine Klimatisierungseinrichtung zur Klimatisierung zugeordnet ist,
- **dass** jeder zu klimatisierenden Baugruppe eine Messeinrichtung zur Temperaturbestimmung zugeordnet ist,
- **dass** die Basisstation eine Logikeinrichtung beinhaltet, an die jede Klimatisierungseinrichtung und jede Messeinrichtung angeschlossen ist, wobei mit Hilfe der Logikeinrichtung gemessene baugruppenspezifische Temperaturen auswertbar und die zugeordneten jeweiligen Klimatisierungseinrichtungen zum Temperaturausgleich entsprechend ansteuerbar sind.

2. Anordnung nach Anspruch 1, **dadurch gekennzeichnet, dass** die Klimatisierungseinrichtung eine steuerbare Kühleinrichtung und/oder eine steuerbare Heizeinrichtung beinhaltet.

3. Anordnung nach Anspruch 1 oder 2, **dadurch gekennzeichnet, dass** die Basisstation zur Umgebungstemperaturbestimmung eine mit der Logikeinrichtung verbundene Umgebungstemperatur-Messeinrichtung und/oder eine von der Logikeinrichtung steuerbare Lüftungsklappe aufweist.

4. Anordnung nach einem der vorhergehenden Ansprüche, **dadurch gekennzeichnet, dass** die Logikeinrichtung einen Programmspeicher zur Speicherung eines Mess- und Steuerungsprogramms und einen Mikroprozessor zur Temperaturauswertung und zur Steuerung der Klimatisierungseinrichtungen aufweist.

5. Anordnung nach Anspruch 4, **dadurch gekennzeichnet, dass** der Programmspeicher über eine Schnittstelle mit einer Fernüberwachungseinrichtung und/oder der Mikroprozessor über eine Schnittstelle mit der Fernüberwachungseinrichtung verbunden ist.

6. Anordnung nach Anspruch 5, **dadurch gekennzeichnet, dass** die Schnittstelle zum Programmspeicher als RS232-Schnittstelle ausgebildet ist.

7. Anordnung nach Anspruch 5, **dadurch gekennzeichnet, dass** die Schnittstelle zum Mikroprozessor als CAN-Bus ausgebildet ist.

8. Anordnung nach einem der Ansprüche 2 bis 7, **dadurch gekennzeichnet, dass** bei einem Notfallbetrieb Lüfter einer Kühleinrichtung eine maximale Drehzahl aufweisen.

9. Anordnung nach einem der vorhergehenden Ansprüche, **dadurch gekennzeichnet, dass** die Logikeinrichtung mit weiteren bei der Basisstation angeordneten Messeinrichtungen zur Bestimmung von Sonneneinwirkung, Feuchte und MEF-Ver-schmutzung verbunden ist, wobei entsprechend gebildete weitere Messwerte bei der Steuerung der Klimatisierungseinrichtungen berücksichtigt werden.

10. Anordnung nach einem der vorhergehenden Ansprüche, **dadurch gekennzeichnet, dass** Messwerte der Messeinrichtungen mindestens zum Teil in einem bei der Fernüberwachungseinrichtung und/oder bei der Logikeinrichtung vorgesehenen Messwertspeicher abgelegt sind.
